# EUROPÄISCHE PATENTANMELDUNG

(11) **EP 1 245 933 A2**
(43) Veröffentlichungstag der Anmeldung: **02.10.2002**
(21) Anmeldenummer: 02005681.8
(22) Anmeldetag: 12.03.2002
(51) Int. Cl.: G01D 11/28

(54) **Elektromechanische Vorrichtung zur Montage einer elektronischen Baugruppe auf einem Baugruppenträger, insbesondere zur Montage eines in einer Armaturentafel eingesenkten Anzeigeinstruments**

(30) Priorität: 30.03.2001 DE 10116008
(71) Anmelder: SIEMENS AKTIENGESELLSCHAFT, 80333 München (DE)
(72) Erfinder: Adams, Jürgen, Dipl.-Ing. (FH), 78052 Villingen-Schwenningen (DE); Wolf, Jürgen, Dipl.-Ing., 78048 Villingen-Schwenningen (DE)

(57) **Zusammenfassung**

Es wird eine elektromechanische Vorrichtung zur Montage einer elektronischen Baugruppe auf einem Baugruppenträger, insbesondere zur Montage eines in einer Armaturentafel eingesenkten Anzeigeinstruments, vorgeschlagen, die durch zumindest einen leitfähigen Klettverbinder zwischen der elektronischen Baugruppe (6) und dem Baugruppenträger (7) gekennzeichnet ist, wobei der leitfähige Klettverbinder sowohl der mechanischen Befestigung als auch der elektrischen Kontaktierung der Baugruppe (6) auf dem Baugruppenträger (7) dient.

## Beschreibung

Die Erfindung betrifft gemäß dem Obergriff des ersten Anspruchs eine elektromechanische Vorrichtung zur Montage einer elektronischen Baugruppe auf einem Baugruppenträger, insbesondere zur Montage eines in einer Armaturentafel eingesenkten Anzeigeinstruments.

Es entspricht gängiger Praxis, eine elektronische Baugruppe auf einem Baugruppenträger zu dessen mechanischer Befestigung zu verschrauben oder durch Klipse zu verrasten. Die elektrische Verbindung zwischen der elektronischen Baugruppe und den Anschlüssen auf dem Baugruppenträger wird bei der bevorzugten Anwendung regelmäßig durch Steckersysteme hergestellt. Bei der Montage eines in einer Armaturentafel eingesenkten Anzeigeinstruments treten aber erschwerende Umstände hinzu. Bei einer in einem Fahrzeug verbauten Armaturentafel sind die Platzverhältnisse zumeist sehr eng und die Zugänglichkeit des Montageortes kann je nach Einbaulage des Anzeigeinstruments bisweilen äußerst schwierig sein. Häufig muß die elektrische Verbindung zwischen dem Anzeigeinstrument und der Armaturentafel vor der mechanischen Befestigung vorgenommen werden, weshalb man Montagehilfen einsetzt, die das Anzeigeinstrument vorübergehend fixieren, so daß die elektrische Verbindung dadurch hergestellt werden kann, daß man die Steckersysteme in Eingriff bringt. Für die Ausführung dieser Tätigkeiten ist die Einbaulage des Anzeigeinstruments in der Armaturentafel mitunter derart ungünstig, daß ein Monteur nicht in seinem Sichtbereich arbeiten kann, sondern zu einer Blindhandlung gezwungen ist, die naturgemäß fehleranfällig ist. Darüber hinaus ist oftmals eine Justierung der Baugruppe auf dem Baugruppenträger notwendig. Üblicherweise bildet man dazu die mechanischen Verbindungselemente mit Toleranzbereichen aus. Der Einbauort eines Anzeigeinstruments in der Armaturentafel mag zum Beispiel ein übergroßes Loch erhalten, Verschraubungen werden mit Langlöchern ausgebildet, Verrastungen erhalten laterale Spielräume. Auf diese Weise wird das Anzeigeinstrument an seinem Einbauort vorgerichtet und fixiert. Montagespalten werden im Regelfall mit einer Blende oder einem Frontrahmen abgedeckt.

Es ist nun die Aufgabe der vorliegenden Erfindung, die Montage einer elektronischen Baugruppe auf einem Baugruppenträger, insbesondere die Montage eines in einer Armaturentafel eingesenkten Anzeigeinstruments, unter Berücksichtigung der meist ungünstigen Einbaubedingungen, insbesondere in einem Fahrzeug, in der Handhabung zu vereinfachen und zugleich durch Ausschaltung von potentiellen Fehlerquellen sicherer zu gestalten.

Die Aufgabe wird durch eine elektromechanische Vorrichtung mit den Merkmalen des ersten Anspruchs gelöst. Kennzeichnende Merkmale bestehen darin, daß die elektromechanische Vorrichtung zumindest aus einem leitfähigen Klettverbinder zwischen der elektronischen Baugruppe und dem Baugruppenträger besteht, der sowohl der mechanischen Befestigung als auch der elektrischen Kontaktierung der Baugruppe auf dem Baugruppenträger dient.

Die abhängigen Ansprüche betreffen Ausgestaltungen der gefundenen Lösung. So kann der Klettverbinder entweder aus einem metallischem Werkstoff, aus einem leitfähigen Kunststoff oder einem mit einem leitfähig beschichteten Kunststoff bestehen. Auch Kombinationen der genannten Ausgestaltungen sind möglich. Ein erfindungsgemäßer Klettverbinder kann auch derart ausgestaltet sein, daß er aus einem Kunststoffträger besteht, in dem ein Metallgeflecht durch Umspritzen eingelagert ist, wobei dann der Kunststoffträger im wesentlichen die erforderlichen elastischen Kräfte aufbringt und das Metallgeflecht die mechanische und die elektrische Verbindung ermöglicht. Bei einer in der Regel zweiteiligen Klettverbinderpaarung könnte auch der eine Teil des leitfähigen Klettverbinders aus Kunststoff bestehen, wohingegen für die Gegenseite dieser Klettverbinderpaarung ein metallisches Gitter vorgesehen ist. Je nach Bedarf können mehrere leitfähige Klettverbinder vorgesehen sein, wodurch für die mechanische Befestigung und die elektrische Kontaktierung gewissermaßen mehrere Inseln bzw. verschiedene Segmente entstehen, die jeweils für sich eine Kontaktstelle bilden. Diese Maßnahme vergrößert zudem die für eine sichere mechanische Befestigung erforderliche Haftfläche, deren Größe vom Gewicht, der dynamischen Beanspruchung und der Einbaulage der Baugruppe abhängt. Durch eine Segmentierung des leitfähigen Klettverbinders sind auch mehrere diskrete elektrische Kontakte für unterschiedliche Signalpfade und elektrische Potentiale realisierbar. Eine möglichst großflächige Ausbildung einer Kontaktstelle wirkt sich günstig auf deren Übergangswiderstand und deren Kontaktsicherheit aus.

Anhand von 3 Figuren soll die Erfindung noch etwas näher erläutert werden, wobei deren besondere Vorteile deutlich werden. So zeigen am Beispiel der Montage eines als Kombiinstrument ausgebildeten Anzeigeinstruments in einer Armaturentafel
- **Figur 1**: eine vereinfachte Längsschnittsdarstellung für ein erfindungsgemäß zu montierendes Kombiinstrument,
- **Figur 2**: ein Beispiel für eine bauträgerseitige Kontaktierung und
- **Figur 3**: eine vereinfachte Darstellung einer Grundplatte eines in der Armaturentafel befindlichen Baugruppenträgers, auf dem die Montage des Kombiinstruments in einer Armaturentafel erfolgt.

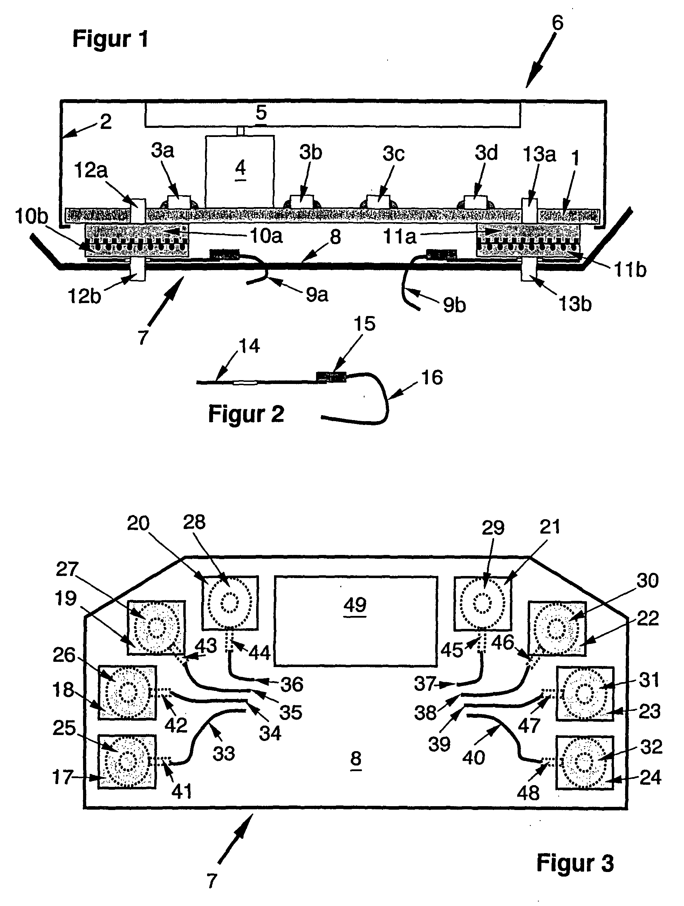

In der **Figur 1** ist in starker Vereinfachung ein Kombiinstrument dargestellt, das aus einer Leiterplatte 1 und einem die Leiterplatte 1 einfassenden Gehäuse 2 besteht. Auf der Leiterplatte 1 sind verschiedene elektronische Bauelemente 3a, 3b, 3c, 3d aufgebracht, aber auch üblicherweise mindestens eine elektromechanische Baugruppe 4 wie beispielsweise an Antrieb für eine hier nur angedeutete analoge Anzeigeeinheit 5. Das Kombiinstrument insgesamt bildet die anspruchsgemäße elektronische Baugruppe 6, die auf einem Baugruppenträger 7 zu montieren ist, wobei der Baugruppenträger 7 in der bevorzugten Anwendung Teil einer Armaturentafel ist oder auch das Chassis des Fahrzeugs sein kann. Der Baugruppenträger 7 kann somit eine mehr oder weniger beliebige Geometrie besitzen, solange er einen Bereich aufweist, der als Montageort für die elektronische Baugruppe 6 geeignet ist. Dieser Montageort wird im folgenden als eine Grundplatte 8 des Baugruppenträgers 7 bezeichnet. Im Regelfall besteht zumindest die Grundplatte 8 des Baugruppenträgers 7 als solche aus einem elektrisch nicht leitfähigen Material oder sie besitzt zumindest an den Stellen, an denen die erfindungsgemäße elektromechanische Vorrichtung angebracht werden soll, eine elektrisch nicht leitfähige Oberfläche.

Erfindungsgemäß erfolgt sowohl die mechanische Befestigung der elektronischen Baugruppe 6 auf der Grundplatte 8 des Baugruppenträgers 7 als auch die elektrische Verbindung zwischen der elektronischen Baugruppe 6 und den elektrischen Anschlüssen 9a, 9b, die seitens des Baugruppenträgers 7 vorgesehen sind und von dort eine elektrische Verbindung zu diversen Einrichtungen in einem Fahrzeug herstellen, durch eine elektromechanische Vorrichtung, die in diesem gezeigten Beispiel aus den beiden leitfähigen Klettverbinderpaarungen 10a, 10b und 11, 11b besteht, die jeweils zweiteilig ausgeführt und zwischen der elektronischen Baugruppe 6 und dem Baugruppenträger 7 angeordnet sind. Dabei ist ein oberer Teil 10a 11 a jeder Klettverbinderpaarung mittels eines leitfähigen Zapfens 12a, 13a an der Leiterplatte 1 angebracht, wohingegen ein unterer Teil 10b, 11b der Klettverbinderpaarung mittels eines nicht notwendigerweise leitfähigen Zapfens 12b, 13b auf der Grundplatte 7 des Baugruppenträgers 6 angebracht ist. Alle Zapfen 12a, 12b, 13a und 13b stehen vom unteren Teil 10b, 11b wie auch vom oberen Teil 10a 11a jeder Klettverbinderpaarung jeweils rückseitig von der Klettfläche ab. Die so auf dem oberen Teil 10a 11a der Klettverbinderpaarung angebrachten Zapfen 12a, 13a tauchen in kontaktierte Bohrungen der Leiterplatte 1 hinein bzw. durch die Leiterplatte 1 hindurch. Durch ihre kraftschlüssige Einbringung in die Leiterplatte 1 bilden die Zapfen 12a, 13a gleichzeitig auch einen elektrischen Kontakt zwischen dem oberen Teil 10a 11 a jeder Klettverbinderpaarung und den hier nicht dargestellten Leiterbahnen der Leiterplatte 1. Die ebenfalls kraftschlüssig in Bohrungen der Grundplatte 8 des Baugruppenträgers 7 eingebrachten Zapfen 12b, 13b am unteren Teil 10b, 11b der Klettverbinderpaarung haben lediglich die Aufgabe der mechanischen Befestigung dieses Teils 10b, 11b der Klettverbinderpaarung auf der Grundplatte 8 des Baugruppenträgers 7, so daß für diese Befestigung auch andere Verbindungstechniken wie beispielsweise Schrauben oder Nieten sinnvoll sein können. Jedoch empfiehlt es sich aus fertigungstechnischen Gründen, beide Teile 10a 10b 11 a, 11b der Klettverbinderpaarung in gleicher Weise auszuführen, weil dadurch die Bauteilvarianten nicht unnötig erhöht wird. In der Figur 1 sind die Zapfen 12a, 12b, 13a und 13b in jeder Klettverbinderpaarung jeweils mittig angeordnet. Diese Anordnung ist nicht zwingend erforderlich, denn es können für jede Klettfläche auch mehrere Zapfen vorgesehen sein, was ihre mechanische Festigkeit und ihre elektrische Kontaktsicherheit verbessert.

Zwischen dem unteren Teil 10b, 11b der Klettverbinderpaarung und der Grundplatte 8 des Baugruppenträgers 7 ist vorzugsweise eine dünne, flächig ausgebildete, elektrisch leitfähige Unterlage zur elektrischen Kontaktierung dieses Teils 10b, 11b der Klettverbinderpaarung vorgesehen, die an dieser Stelle lediglich verklemmt oder zu ihrer Fixierung verklebt sein kann. Wie die Figur 2 in einer Einzelteildarstellung zeigt, besteht diese bauträgerseitige Kontaktierung zum Beispiel aus einem Kontaktring oder aus einer flachen metallischen gelochten Unterlegscheibe 14. An dem Kontaktring bzw. der Unterlegscheibe 14 ist beispielsweise ein Crimpschuh 15 für ein fahrzeugseitiges elektrisches Kabel 16 angebracht, welches zu diversen elektrischen Einrichtungen in dem Fahrzeug führt. Für eine gute elektrische Kontaktsicherheit sollte die leitfähige Unterlage zur elektrischen Kontaktierung des unteren Teils 10b 11b der Klettverbinderpaarung in Analogie zu dem in Verbindung mit dem oberen Teil 10a 11 a der Klettverbinderpaarung Gesagten ebenso möglichst großflächig ausgebildet sein.

Die **Figur 3** stellt in vereinfachter Form in einer dem zu montierenden Kombiinstrument zugewandten Draufsicht eine Grundplatte 8 eines in der Armaturentafel befindlichen Baugruppenträgers 7 dar, auf dem die Montage des Kombiinstruments in der Armaturentafel erfolgt. Hier sind mehrere, auf der Grundplatte 8 befestigte untere Teile 17 bis 24 der Klettverbinderpaarung gezeigt, die jeweils zur bauträgerseitigen Kontaktierung mit einer metallischen Unterlegscheibe 25 bis 32 unterlegt sind. An den Unterlegscheiben 25 bis 32 sind elektrische Leitungen 33 bis 40 halternde Kontaktschuhe 41 bis 48 angebracht, wobei die elektrischen Leitungen 33 bis 40 zu verschiedenen elektrischen Einrichtungen in dem Fahrzeug führen. Außerdem zeigt die Figur 3 auf der Grundplatte 8 eine im Vergleich zu den unteren Teilen 17 bis 24 der leitfähigen Klettverbinderpaarung größere Klettfläche 49 eines unteren Teils einer Klettverbinderpaarung, die nicht leitfähig ausgebildet ist, sondern lediglich optional vorgesehen ist, um die Haftfläche zwischen der zu montierenden Baugruppe 6 und dem Baugruppenträger 7 zu erhöhen. Es versteht sich, daß auf der Baugruppe 6 an entsprechender Stelle ein Gegenstück zu dieser aus einem Klettverbinder bestehenden Klettfläche 49 vorgesehen ist.

Bei der hier aufgezeigten Lösung wird ein an sich bekannter Klettverbinder zu einer elektromechanischen Vorrichtung weiterentwickelt, um gleichzeitig sowohl eine mechanische Befestigung als auch eine elektrische Kontaktierung vorzunehmen. Bei einem Klettverbinder greifen bekanntermaßen eine hohe Anzahl von elastisch ausgebildeten Formelementen wie Zapfen, Haken, Ösen oder Stifte derart ineinander, daß die Formelemente durch elastische Verformung und Hintergreifungen partielle Verrastungen vornehmen. Die Summe der einzelnen Verrastungen erzeugt dann die notwendigen Halte- und Scherkräfte für die mechanische Fixierung. Für die hier aufgezeigte bevorzugte Anwendung der vorgeschlagenen Lösung ist es wichtig, daß von den Verrastungen ausreichend hohe Scherkräfte aufgenommen werden können, damit eine solche Montage auch den einschlägigen Unfallvorschriften genügt, wenn mit diesen Lösungsmitteln der Einbau eines Anzeigeinstruments in einer Armaturentafel in einem Fahrzeug erfolgt. Diesem Erfordernis kann durch eine geeignete Geometrie der Formelemente und durch ihre Anzahl entsprochen werden. Andernfalls bestünde durch die dynamischen Beanspruchungen in einem Fahrzeug die Gefahr unzureichender Ortsbeständigkeit einer so auf einem Baugruppenträger montierten Baugruppe.

Die mechanische Befestigung eines Anzeigeinstruments mit einem leitfähigen Klettverbinder hat den Vorteil, daß eine nahezu beliebige Positionierung und laterale Ausrichtung der elektronischen Baugruppe auf dem Baugruppenträger bzw. des Anzeigeinstruments in einer Armaturentafel möglich wird.

Da moderne Kombiinstrumente durch den zunehmenden Einsatz von Datenbussystemen im Fahrzeug mittlerweile nur noch verhältnismäßig wenige Kontaktelemente zu ihrer elektrischen Versorgung und zur Datenübertragung benötigen, ist eine Realisierung der vorgeschlagenen Lösung sehr vorteilhaft, weil sie den Aufwand zur Montage einer elektronischen Baugruppe auf einem Baugruppenträger, insbesondere die Montage eines Anzeigeinstruments in einer Armaturentafel, deutlich reduziert. Bei der Montage werden die Klettverbinderpaarungen im Rahmen eines bestimmten Toleranzbereichs auf der Grundplatte 8 des Baugruppenträgers 7 miteinander zur Deckung gebracht. Zur Justierung der Baugruppe kann wie bisher entweder ein System von einfachen Leeren verwendet werden oder die Aufnahme in der Armaturentafel führt die Baugruppe zu ihrer Endposition auf dem Baugruppenträger mittels Führungsrippen oder anderer ähnlicher Mittel. Die Baugruppe wird dann letztlich durch einen gezielten Anpreßdruck mittels der Formelemente der Klettverbinder verrastet, womit dann zugleich auch erfindungsgemäß die elektrische Verbindung zwischen der Baugruppe und den Anschlüssen auf dem Baugruppenträger hergestellt ist.

## Patentansprüche

1. Elektromechanische Vorrichtung zur Montage einer elektronischen Baugruppe auf einem Baugruppenträger, insbesondere zur Montage eines in einer Armaturentafel eingesenkten Anzeigeinstruments, **gekennzeichnet durch** zumindest einen leitfähigen Klettverbinder zwischen der elektronischen Baugruppe (6) und dem Baugruppenträger (7), der sowohl der mechanischen Befestigung als auch der elektrischen Kontaktierung der Baugruppe (6) auf dem Baugruppenträger (7) dient.

2. Elektromechanische Vorrichtung nach Anspruch 1, **dadurch gekennzeichnet, daß** eine Grundplatte (8) des Baugruppenträgers (7) aus einem elektrisch nicht leitfähigen Material besteht oder daß die Grundplatte (8) zumindest an den Stellen, an denen die elektromechanische Vorrichtung angebracht werden soll, eine elektrisch nicht leitfähige Oberfläche besitzt.

3. Elektromechanische Vorrichtung nach einem der vorangegangenen Ansprüche, **dadurch gekennzeichnet, daß** der Klettverbinder entweder aus einem metallischem Werkstoff, aus einem leitfähigen Kunststoff, einem mit einem leitfähig beschichteten Kunststoff oder einer Kombination dieser Ausgestaltungen besteht.

4. Elektromechanische Vorrichtung nach einem der vorangegangenen Ansprüche, **dadurch gekennzeichnet, daß** der leitfähige Klettverbinder aus einem Kunststoffträger besteht, in dem ein Metallgeflecht eingelagert ist.

5. Elektromechanische Vorrichtung nach einem der vorangegangenen Ansprüche, **dadurch gekennzeichnet, daß** bei einer Klettverbinderpaarung der eine Teil aus einem leitfähigen Klettverbinder aus Kunststoff besteht und für die Gegenseite dieser Klettverbinderpaarung ein metallisches Gitter vorgesehen ist.

6. Elektromechanische Vorrichtung nach einem der vorangegangenen Ansprüche, **dadurch gekennzeichnet, daß** mehrere Segmente von dem leitfähigen Klettverbinder vorgesehen sind.

7. Elektromechanische Vorrichtung nach einem der vorangegangenen Ansprüche, **dadurch gekennzeichnet, daß** bei einer Klettverbinderpaarung ihr oberer Teil (10a, 11a) mittels eines leitfähigen Zapfens (12a, 13a) an einer Leiterplatte (1) der elektronischen Baugruppe (6) angebracht ist, wohingegen der untere Teil (10b 11b) der Klettverbinderpaarung mittels eines nicht notwendigerweise leitfähigen Zapfens (12b, 13b) auf einer Grundplatte (7) des Baugruppenträgers (6) angebracht ist, wobei alle Zapfen (12a, 12b, 13a und 13b) vom unteren Teil (10b, 11b) wie auch vom oberen Teil (10a, 11a) jeder Klettverbinderpaarung jeweils rückseitig von der Klettfläche abstehen.

8. Elektromechanische Vorrichtung nach einem der vorangegangenen Ansprüche, **dadurch gekennzeichnet, daß** die auf dem oberen Teil (10a, 11a) einer Klettverbinderpaarung angebrachten Zapfen (12a, 13a) in kontaktierte Bohrungen der Leiterplatte (1) hineintauchen bzw. durch die Leiterplatte (1) hindurchstossen.

9. Elektromechanische Vorrichtung nach einem der vorangegangenen Ansprüche, **dadurch gekennzeichnet, daß** die auf dem oberen Teil (10a, 11a) einer Klettverbinderpaarung angebrachten Zapfen (12a, 13a) kraftschlüssig in die Leiterplatte (1) eingebracht sind und gleichzeitig einen elektrischen Kontakt zwischen dem oberen Teil (10a, 11 a) jeder Klettverbinderpaarung und der Leiterplatte (1) bilden.

10. Elektromechanische Vorrichtung nach einem der vorangegangenen Ansprüche, **dadurch gekennzeichnet, daß** für jede Klettfläche mehrere Zapfen vorgesehen sind.

11. Elektromechanische Vorrichtung nach einem der vorangegangenen Ansprüche, **dadurch gekennzeichnet, daß** zwischen dem unteren Teil (10b 11b) der Klettverbinderpaarung und dem Baugruppenträger (7) eine elektrisch leitfähige Unterlage zur elektrischen Kontaktierung dieses Teils (10b 11b) der Klettverbinderpaarung vorgesehen ist.

12. Elektromechanische Vorrichtung nach einem der vorangegangenen Ansprüche, **dadurch gekennzeichnet, daß** die elektrisch leitfähige Unterlage dünn und flächig ausgebildet ist.

13. Elektromechanische Vorrichtung nach einem der vorangegangenen Ansprüche, **dadurch gekennzeichnet, daß** die elektrisch leitfähige Unterlage verklemmt oder verklebt ist.

14. Elektromechanische Vorrichtung nach einem der vorangegangenen Ansprüche, **dadurch gekennzeichnet, daß** die elektrisch leitfähige Unterlage aus einem Kontaktring oder aus einer flachen metallischen gelochten Unterlegscheibe (14) besteht.
